# EUROPEAN PATENT APPLICATION

(11) **EP 1 737 277 A1**
(43) Date of publication of application: **27.12.2006**
(21) Application number: 05728719.5
(22) Date of filing: 08.04.2005
(51) Int. Cl.: H05B 33/14, C09K 11/06

(54) **ORGANIC ELECTROLUMINESCENT DEVICE**

(30) Priority: 15.04.2004 JP 2004120823
(71) Applicant: IDEMITSU KOSAN CO., LTD., Tokyo 100-8321 (JP)
(72) Inventor: FUNAHASHI, Masakazu, 2990293 (JP)
(74) Representative: Gille Hrabal Struck Neidlein Prop Roos
(86) International application number: PCT/JP2005/006898
(87) International publication number: WO 2005/101913

(57) **Abstract**

An organic EL device comprising a pair of electrodes consisting of an anode and a cathode, and an organic light emitting medium layer sandwiched between the pair of electrodes consisting of an anode and a cathode, wherein an organic light emitting medium layer contains a component (A): at least one selected from substituted or unsubstituted arylamine compounds having 10 to 100 carbon atoms, and a component (B): at least one selected from the general formula (Ar₁)ₐ⁻L (I), wherein Ar₁ represents a substituted or unsubstituted aromatic hydrocarbon group having 6 to 30 carbon atoms, or a substituted or unsubstituted aromatic heterocyclic group having 3 to 30 carbon atoms, a represents an integer of 2 to 6,
a plural Ar₁ may be the same with or different from each other, and L represents a substituted or unsubstituted a-valent moiety of a condensed polycyclic aromatic ring having 4 to 10 rings, and the device has excellent heat resistance and long lifetime, exhibits high current efficiency, and emits light in the range of green to pure red.

## Description

### TECHNICAL FIELD

The present invention relates to an organic electroluminescent ("electroluminescent" will be occasionally referred to as "EL", hereinafter) device, in particular, to an organic electroluminescent device having excellent heat resistance and a long lifetime and exhibiting high current efficiency, and also emitting a light in the range of from green to pure red.

### BACKGROUND ART

An organic electroluminescent device is a spontaneous light emitting device which utilizes the principle that a fluorescent substance emits light by energy of recombination of holes injected from an anode and electrons injected from a cathode when an electric field is applied.
Since an organic EL device of the laminate type driven under a low electric voltage was reported by C. W. Tang et al. of Eastman Kodak Company (C. W Tang and S. A. Vanslyke, Applied Physics Letters, Volume 51, Page 913, 1987), many studies have been conducted on organic EL devices using organic materials as the constituting materials.
Tang et al. used a laminate structure using tris(8-quinolinol) aluminum for the light emitting layer and a triphenyldiamine derivative for the hole transporting layer. Advantages of the laminate structure are that the efficiency of hole injection into the light emitting layer can be increased, that the efficiency of forming excimers which are formed by blocking and recombining electrons injected from the cathode can be increased, and that excimers formed among the light emitting layer can be enclosed. As the structure of the organic EL device, a two-layered structure having a hole transporting (injecting) layer and an electron transporting and light emitting layer and a three-layered structure having a hole transporting (injecting) layer, a light emitting layer and an electron transporting (injecting) layer are well known. To increase the efficiency of recombination of injected holes and electrons in the devices of the laminate type, the structure of the device and the process for forming the device have been studied.
As the light emitting material of the organic EL device, chelate complexes such as tris(8-quinolinol)aluminum, coumarin derivatives, tetraphenylbutadiene derivatives, bisstyrylarylene derivatives and oxadiazole derivatives are known. It is reported that light in the visible region ranging from blue light to red light can be obtained by using these light emitting materials, and development of a device exhibiting color images is expected (refer to, for example, Patent literatures 1, 2 and 3). However, the materials exhibited insufficient current efficiency and a lifetime which were off from practical use level. In addition, three primary colors (blue, green and red) have been required for full color displays. In particularly a high efficient device emitting a green light and a red light, and more particularly a high efficient device emitting a pure red light has been required.

Recently, for example, the devices employing aminoanthracene derivatives as the material for emitting a green light was disclosed in Patent literature 4. However, the heat resistance of organic EL devices employing these materials was low due to the low glass transition temperature thereof, so that a device exhibiting a long lifetime and high current efficiency was not obtained. The devices having the light emitting layer comprising a naphthacene derivative or a pentacene derivative and emitting a red light, were disclosed in Patent literature 5. Although the light emitting device emitted a red light with excellent purity, the applied voltage was as high as 11 V, therefore the half-lifetime of the luminance was only 1500 hours and come short. The devices having the light emitting layer comprising amine based aromatic compounds and emitting a red light, were disclosed in Patent literature 6. Although the devices exhibited the color purity of CIE chromaticity (0.64, 0.33), the driving voltage was as high as 10V or more. The devices having the light emitting layer comprising the azafluoranthene compound were disclosed in Patent literature 7. However, they emitted a light in the range of from yellow to green, but could not emit a red light adequately. The devices having the light emitting layer comprising anthracene derivatives and arylamine derivatives and emitting a green light were disclosed in Patent literature 8. However, the anthracene derivatives for these devices could not emit red light adequately. The devices having the light emitting layer comprising the styrylnaphthacene derivatives and emitting a green light were disclosed in Patent literature 9. The current efficiency was about 13 cd/A, therefore, further improvement is expected. The devices having the light emitting layer comprising naphthacene derivatives were disclosed in Patent literature 10 and 11. The emitted light was orange, thus red light was not emitted adequately.

[Patent literature 1] Japanese Patent Application Laid-Open No. Heisei 8(1996)-239655
[Patent literature 2] Japanese Patent Application Laid-Open No. Heisei 7(1995)-138561
[Patent literature 3] Japanese Patent Application Laid-Open No. Heisei 3(1991)-200289
[Patent literature 4] Japanese Patent Application Laid-Open No. 2001-207167
[Patent literature 5] Japanese Patent Application Laid-Open No. Heisei 8(1996)-311442
[Patent literature 6] Japanese Patent Application Laid-Open No. 2001-81451
[Patent literature 7] Japanese Patent Application Laid-Open No. 2001-160489
[Patent literature 9]: International publication No. WO 2004/018588
[Patent literature 9] Japanese Patent Application Laid-Open No. 2000-268963
[Patent literature 10] Japanese Patent Application Laid-Open No. 2000-26334
[Patent literature 11] Japanese Patent Application Laid-Open No. 2000-26337

### DISCLOSURE OF THE INVENTION

### PROBLEMS TO BE SOLVED BY THE INVENTION

The present invention has been made to overcome the above problems and has an objective of providing an organic electroluminescent device having excellent heat resistance and a long lifetime, exhibiting high current efficiency, and emitting a light in the range of from green to pure red.

### MEANS FOR SOLVING THE PROBLEM

As a result of intensive researches and studies to achieve the above objective by the present inventors, it was found that having a combination of an arylamine compound and a specific structure compound containing a specific structured condensed ring represented by the following general formula (I) contained in an organic light emitting medium layer enables to achieve the above objective and thus the present invention was accomplished.
Namely, the present invention provides an organic EL device comprising a pair of electrodes, and an organic light emitting medium layer sandwiched by the said electrodes, wherein the organic light emitting medium layer contains at least one compound (A) selected from substituted or unsubstituted arylamine compounds having 10 to 100 carbon atoms, and at least one compound (B) selected from the compounds containing a condensed ring represented by the general formula (I).

(Ar₁)ₐ-L (I)

In the general formula (I), Ar₁ represents a substituted or unsubstituted aromatic hydrocarbon group having 6 to 30 carbon atoms, or a substituted or unsubstituted aromatic heterocyclic group having 3 to 30 carbon atoms, a represents an integer of 2 to 6, a plural Ar₁ may be the same or different from each other, and L represents a substituted or unsubstituted a-valent moiety of a condensed polycyclic aromatic ring having 4 to 10 rings.

### EFFECT OF THE INVENTION

The organic EL device of the present invention exhibits excellent heat resistance and high current efficiency, and has a long lifetime, and also emits a light in the range of from green to pure red.

### THE PREFERRED EMBODIMENT TO CARRY OUT THE INVENTION

The organic EL device of the present invention is explained in details as follows; The organic EL device of the present invention provides an organic EL device comprising a pair of electrodes and an organic light emitting medium layer sandwiched by the said electrodes, wherein the organic light emitting medium layer contains at least one compound (A) selected from substituted or unsubstituted arylamine compounds having 10 to 100 carbon atoms, and at least one compound (B) selected from the compounds containing a condensed ring, represented by the general formula (I):

(Ar₁)ₐ-L (I)

wherein Ar₁ represents a substituted or unsubstituted aromatic hydrocarbon group having 6 to 30 carbon atoms, or a substituted or unsubstituted aromatic heterocyclic group having 3 to 30 carbon atoms, a represents an integer of 2 to 6, a plural Ar₁ may be the same or different from each other, and L represents a substituted or unsubstituted a-valent moiety of a condensed polycyclic aromatic ring having 4 to 10 rings.

Firstly, the following explains component (A) to be contained in the aforementioned organic light emitting medium layer of the organic EL device of the present invention. An arylamine compound having 30 to 100 carbon atoms as the component (A) is preferable. The arylamine compound as the component (A) includes, for example, an arylamine compound represented by the following general formula (II).

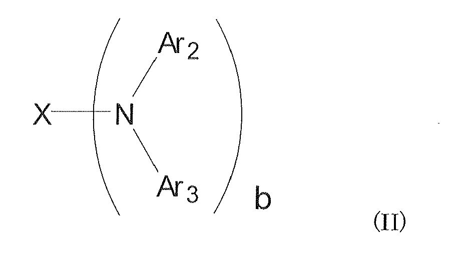

In the general formula (II), X represents a condensed aromatic ring group having 10 to 40 ring carbon atoms, Ar₂ and Ar₃ each independently represents a substituted or unsubstituted monovalent aromatic hydrocarbon group having 6 to 40 carbon atoms, or a substituted or unsubstituted monovalent aromatic heterocyclic group having 3 to 40 carbon atoms, and b represents an integer of 1 to 4.

The condensed aromatic ring group of X in the general formula (II) includes, for example, a moiety of naphthalene, phenanthrene, fluoranthene, anthracene, pyrene, perylene, coronene, chrysene, picene, diphenylanthracene, fluorene, triphenylene, rubicene, benzanthracene, dibenzanthracene, acenaphthofluoranthene , tribenzopentaphene, fluoranthenofluoranthene, benzodifluoranthene, benzofluoranthene and diindenoperylene, and moieties of pyrene, anthracene, benzofluoranthene and acenaphtofluoranthene are preferable.
The monovalent aromatic hydrocarbon group and aromatic heterocyclic group of Ar₂ and Ar₃ in the general formula (II) includes, for example, a phenyl group, a naphthyl group, an anthranyl group, a phenanthryl group, a pyrenyl group, a coronyl group, a biphenyl group, a terphenyl group, a fluorenyl group, a furanyl group, a thienyl group, a benzothienyl group, an indryl group, a carbazolyl group, a furyl group, a pyrrolyl group and a pyridyl group, and a phenyl group, a naphthyl group, a pyrenyl group and a biphenyl group are preferable.

The arylamine compound represented by the general formula (II) includes arylamine compounds represented by the following general formulae (II-a) and (II-a').

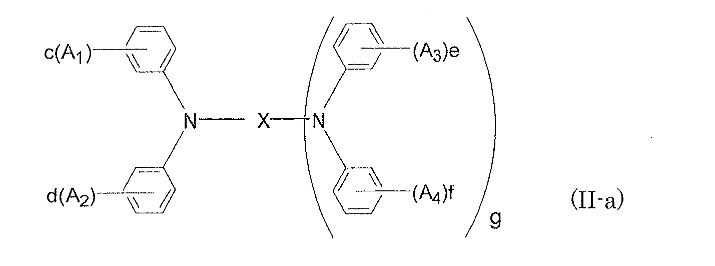

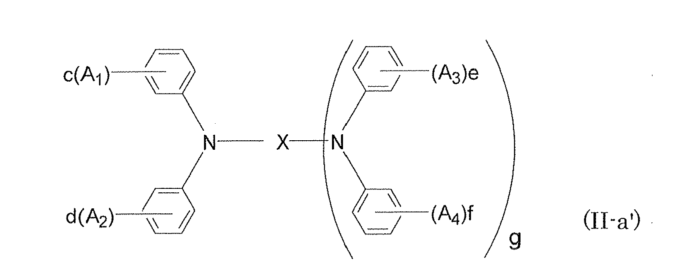

X in the general formulae (II-a) and (II-a') is the same with the aforementioned. A₁ to A₄ in the general formulae (II-a) and (II-a') each independently represents a hydrogen atom, a substituted or unsubstituted alkyl group having 1 to 50, preferably 1 to 20, carbon atoms, a substituted or unsubstituted aromatic hydrocarbon group having 5 to 50, preferably 5 to 20, carbon atoms, a substituted or unsubstituted aralkyl group having 7 to 50, preferably 7 to 40, carbon atoms, a substituted or unsubstituted cycloalkyl group having 3 to 50, preferably 5 to 12, ring carbon atoms, a substituted or unsubstituted alkoxyl group having 1 to 50, preferably 1 to 6, carbon atoms, a substituted or unsubstituted aryloxyl group having 5 to 50, preferably 5 to 18, ring carbon atoms, a substituted or unsubstituted arylamino group having 5 to 50, preferably 5 to 18 ring carbon atoms, or a substituted or unsubstituted alkylamino group having 1 to 20, preferably 1 to 6, carbon atoms.

A substituted or unsubstituted alkyl group of A₁ to A₄ includes, for example, methyl group, ethyl group, propyl group, isopropyl group, butyl group, sec-butyl group, tert-butyl group, pentyl group, hexyl group, heptyl group, octyl group, stearyl group, 2-phenylisopropyl group, trichloromethyl group, trifluoromethyl group, benzyl group, α-phenoxybenzyl group, α,α-dimethylbenzyl group, α,α-methylphenylbenzyl group, α,α-ditrifluoromethylbenzyl group, triphenylmethyl group, α-benzyloxybenzyl group and the like.
A substituted or unsubstituted aromatic hydrocarbon group of A₁ to A₄ includes, for example, a phenyl group, a 2-metylphenyl group, a 3-methylphenyl group, a 4-methylphenyl group, a 4-ethylphenyl group, a biphenyl group, a 4-methylbiphenyl group, a 4-ethylbiphenyl group, a 4-cyclohexylbiphenyl group, a terpheyl group, a 3,5-dichlorophenyl group, a naphthyl group, a 5-methylnaphthyl group, an anthryl group, a pyrenyl group and the like.

A substituted or unsubstituted aralkyl group of A₁ to A₄ includes a benzyl group, a 1-phenylethyl group, a 2-phenylethyl group, a 1-plzenylisopropyl group, a 2-phenylisopropyl group, a phenyl-t-butyl group, an α-naphthylmethyl group, a 1-α-naphthylethyl group, a 2-α-naphthylethyl group, a 1-α-naphthylisopropyl group, a 2-α-naphthylisopropyl group, a β-naphthylmethyl group, a 1-β-naphthylethyl group, a 2-β-naphthylethyl group, a 1-β-naphthylisopropyl group, a 2-β-naphthylisopropyl group, a 1-pyrrolylmethyl group, a 2-(1-pyrrolyl)ethyl group, a p-methylbenzyl group, a m-methylbenzyl group, an o-methylbenzyl group, a p-chlorobenzyl group, a m-chlorobenzyl group, an o-chlorobenzyl group, a p-bromobenzyl group, a m-bromobenzyl group, an o-bromohenzyl group, a p-iodobenzyl group, a m-iodobenzyl group, an o-iodobenzyl group, a p-hydroxybenzyl group, a m-hydroxybenzyl group, an o-hydroxybenzyl group, a p-aminobenzyl group, a m-aminobenzyl group, an o-aminobenzyl group, a p-nitrobenzyl group, a m-nitrobenzyl group, an o-nitrobenzyl group, a p-cyanobenzyl group,a m-cyanobenzyl group, an o-cyanobenzyl group, a 1-hydroxy-a 2-phenylisopropyl group, a 1-chloro-2-phenylisopropyl group and the like.

A substituted or unsubstituted cycloalkyl group of A₁ to A₄ includes, for example, a cyclopropyl group, a cyclobutyl group, a cyclopentyl group, a cyclohexyl group and the like.
A substituted or unsubstituted alkoxyl group of A₁ to A₄ includes, for example, a methoxy group, an ethoxy group, a propoxy group, an isopropoxy group, a butoxy group, an isobutoxy group, a sec-butoxy group, a tert-butoxy group, various pentyloxy groups, various hexyloxy groups and the like.
A substituted or unsubstituted aryloxy group of A₁ to A₄ includes, for example, a phenoxy group, a tolyloxy group, a naphthyloxygroup and the like.
A substituted or unsubstituted arylamino group of A₁ to A₄ includes, for example, a diphenylamino group, a ditolylamino group, a dinaphthylamino group, a naphthylphenylamino group and the like.
A substituted or unsubstituted alkylamino group includes, for example, a dimetylamino group, a diethylamino group, a dihexylamino group and the like.

c, d, e, and f of the general formulae (II-a) and (II-a') each represents an integer of 0 to 5, preferably 0 to 2. When c, d, e, and/or f represent 2 or larger, a plural A₁ to A₄ each may be the same or different from each other, and also may bond each other to form a saturated or unsaturated ring. g represents an integer of 0 to 4. However, at least one of A₁ to A₄ in the general formula (II-a) represents a substituted or unsubstituted sec⁻ or tert-alkyl group having 3 to 10 carbon atoms. A sec- or tert-alkyl group includes a sec- or tert-alkyl group among the aforementioned alkyl groups of A₁ to A₄. In addition, at least one of c, d, e, and f in the general formula (II-a') represents an integer of 2 or larger.

An arylamine compound represented by the general formula (II) includes preferably an arylamine compound represented by the general formulae (II-b) and (II-b'). 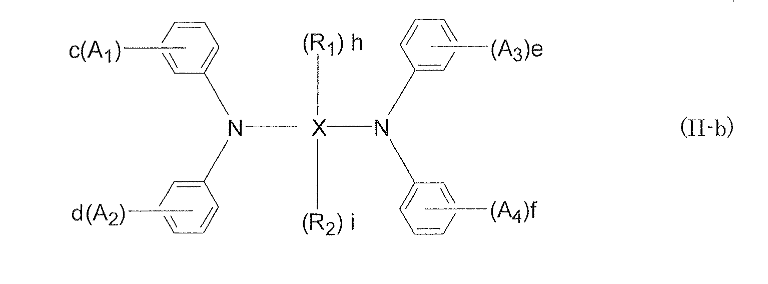 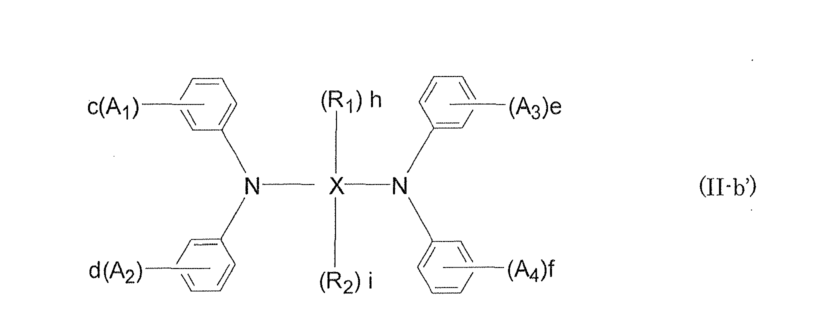 In the general formulae (II-b) and (II-b'), X, A₁ to A₄, c, d, e, and f each independently represents the same with those of the general formulae (II-a) and (II-a'), and when c, d, e, and/or f represent 2 or larger, a plural A₁ to A₄ each may be the same with or different from each other, and also may bond each other to form a saturated or unsaturated ring.

R₁ and R₂ in the general formulae (II-b) and (II-b') each independently represents a hydrogen atom, a substituted or unsubstituted alkyl group having 1 to 10, preferably 1 to 6, carbon atoms, a substituted or unsubstituted aromatic hydrocarbon group having 6 to 20, preferably 6 to 14, carbon atoms, a substituted or unsubstituted aralkyl group having 7 to 50, preferably 7 to 40, carbon atoms, a substituted or unsubstituted alkoxyl group having 1 to 50, preferably 1 to 6, carbon atoms, and a substituted or unsubstituted aryloxyl group having 5 to 50, preferably 5 to 18, ring carbon atoms.
Specific examples of these groups include those groups selected from the aforementioned A₁ to A₄ groups which have the corresponding number of carbon atoms. h and i in the general formula (II-b) and (II-b') each represents an integer of 0 to 2. However, at least one of A₁ to A₄ in the general formula (II-b) is a substituted or unsubstituted sec- or tert-alkyl group having 3 to 10 carbon atoms. In addition, in the general formula (II-b'), at least one of c, d, e, and f is an integer of 2 or larger.

In the present invention, an arylamine compound of the component (A) may be used solely or two or more kinds in combination. Substituent in the general formulae (II), (II-a), (II-a'), (II-b), and (II-b') includes an alkyl group having 1 to 6 carbon atoms, a cycloalkyl group having 3 to 6 carbon atoms, an alkoxyl group having 1 to 6 carbon atoms, an aryloxy group having 5 to 18 carbon atoms, an aralkyloxy group having 7 to 18 carbon atoms, an arylamino group having 5 to 16 carbon atoms, a nitro group, a cyano group, an ester group having 1 to 6 carbon atoms, a halogen atom and the like. The following is examples of an arylamine compounds represented by the general formulae (II), (II-a), (II-a'), (II-b), and (II-b'), but not limited thereto. Here, Me means a methyl group.

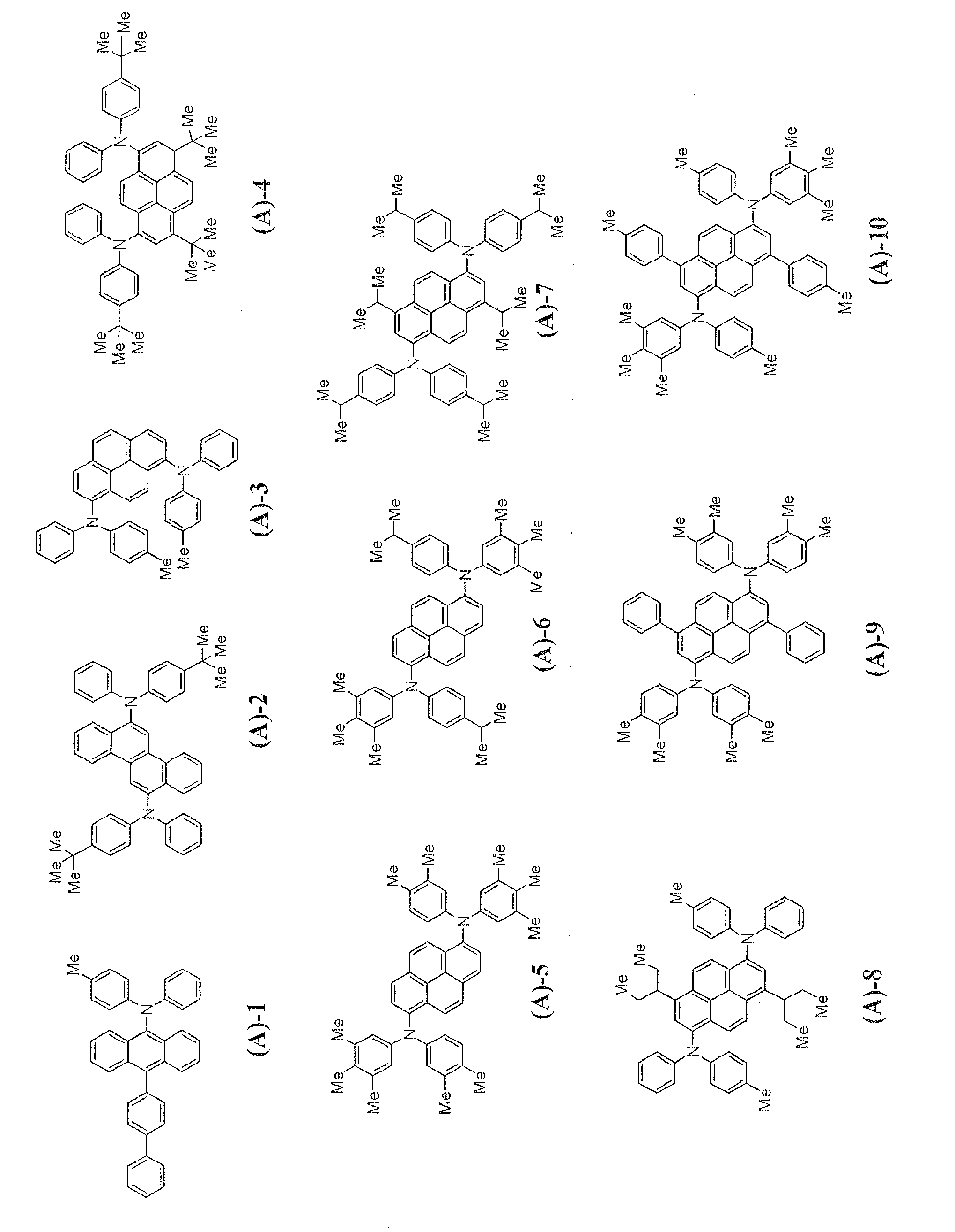

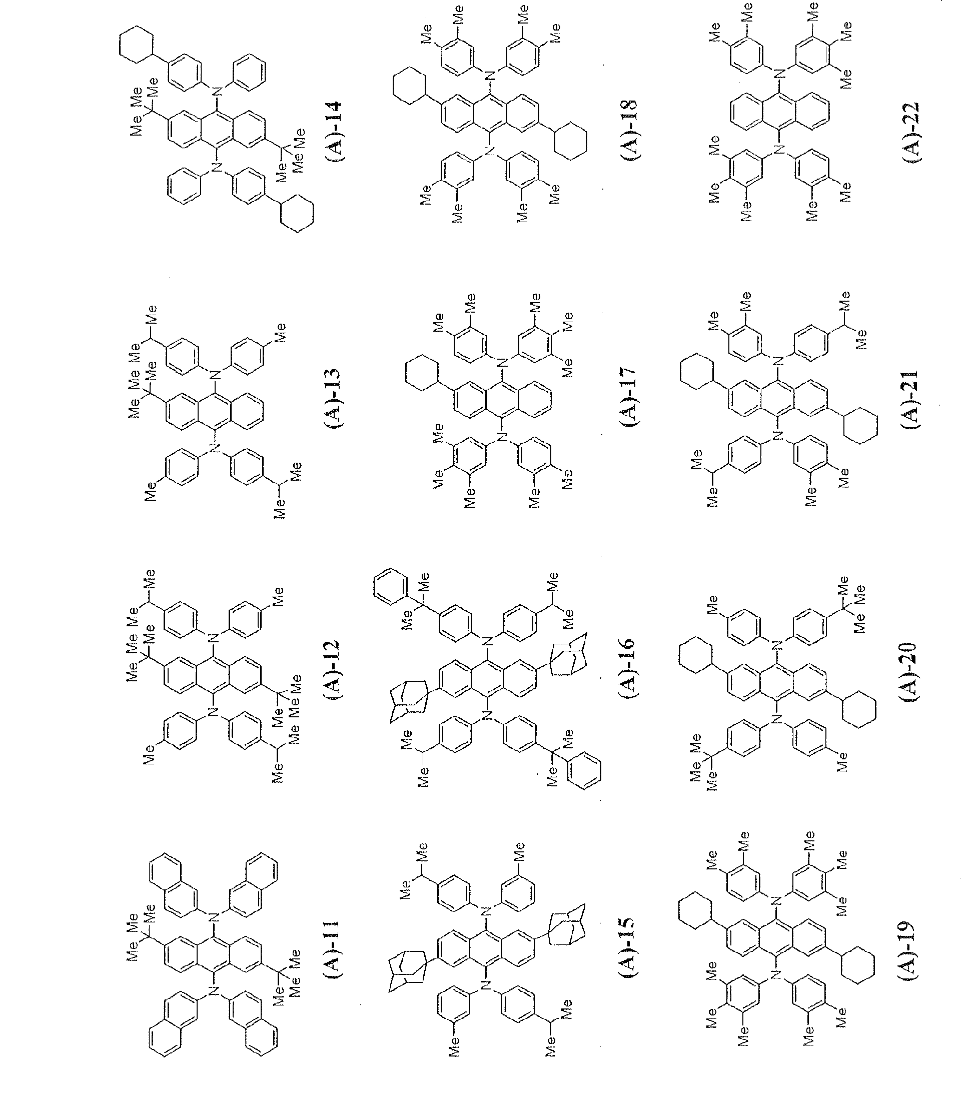

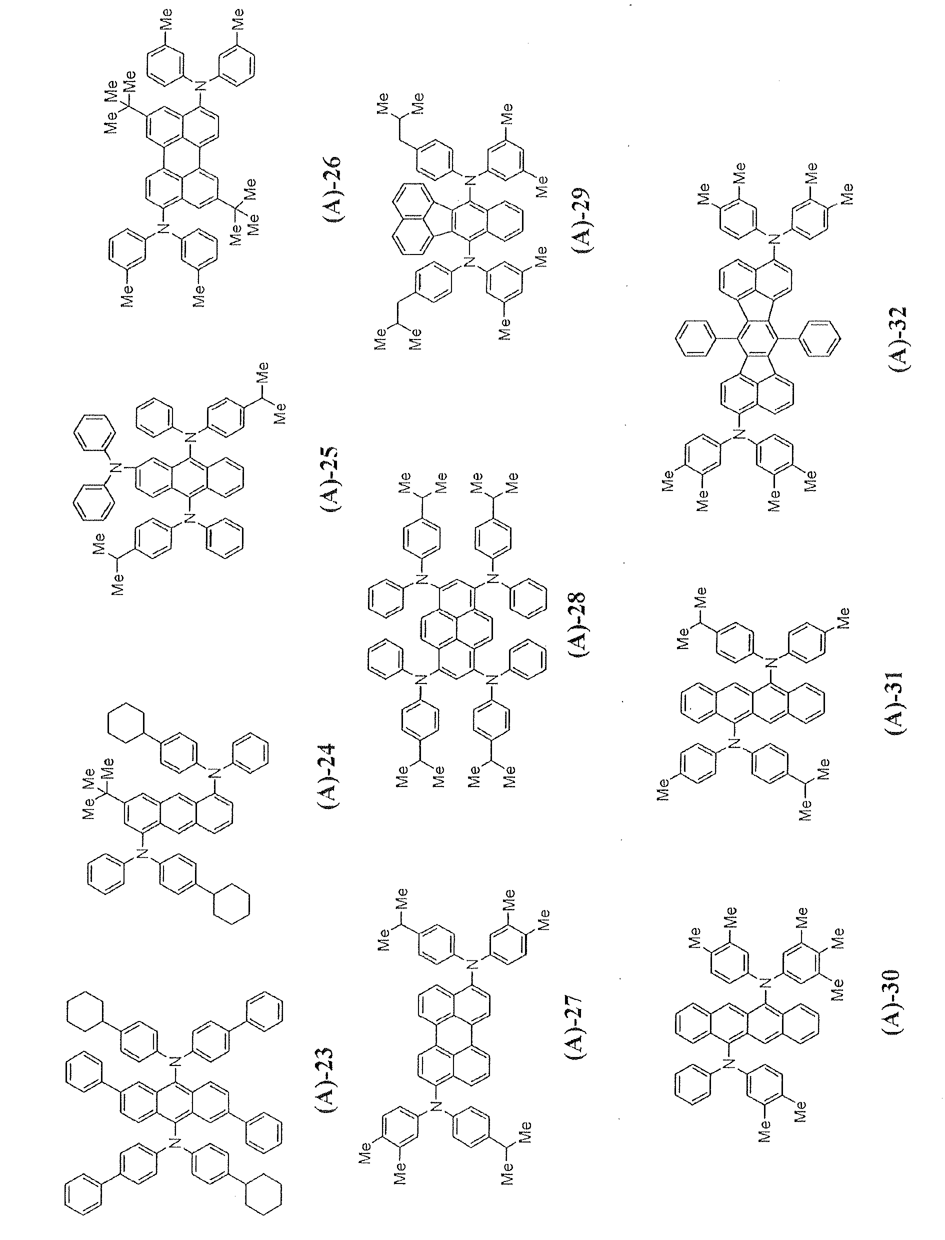

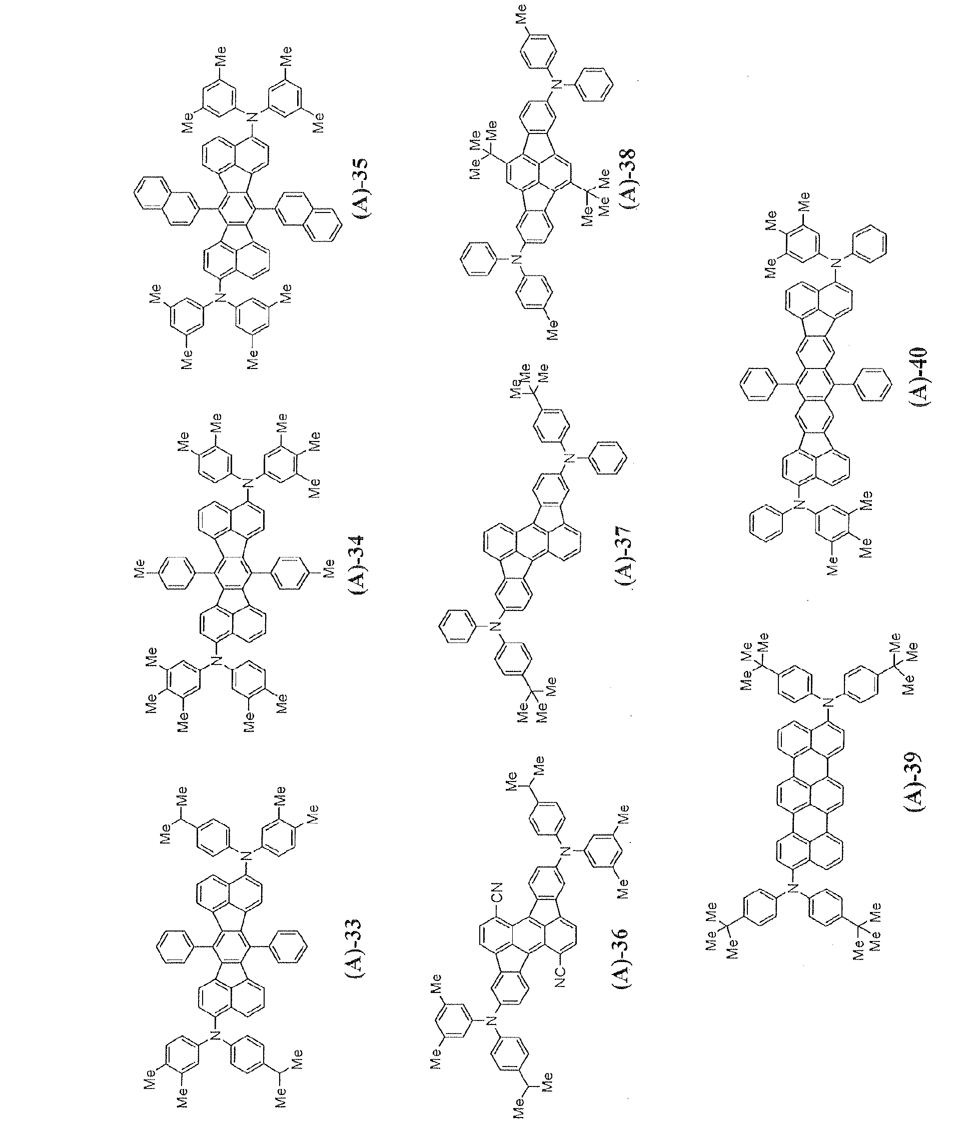

Subsequently, a compound containing a condensed ring represented by the aforementioned general formula (I) as the component (B) to be contained into the organic light emitting medium layer in the organic EL device of the present invention, is explained as follows; In the general formula (I), an aromatic hydrocarbon group of Ar₁ may include any hydrocarbon group having a benzene ring, and also include a monocyclic or polycyclic aromatic hydrocarbon group. A condensed ring or aggregated rings may be included. Therefore, examples thereof include a phenyl group, an alkylphenyl group, an alkoxyphenyl group, an arylphenyl group, an aryloxyphenyl group, an alkenylphenyl group, an aminophenyl group, a naphthyl group, an anthryl group, a pyrenyl group, a perylenyl group and the like. In addition, an arylalkynyl group derived from an alkynylarene "arylalkyne" may be included.
Further, an aromatic hetero ring group of Ar₁ contains preferably O, N or S as the hetero atom, and also a 6 member ring as well as a 5 member ring may be included. Examples thereof include a thienyl group, a furyl group, a pyrrolyl group, a pyridyl group, and the like.
In the general formula (I), substituent for an aromatic hydrocarbon group and an aromatic hetero ring group includes an alkyl group, an alkoxy group, an aryl group, an aryloxy group, an amino group, a heterocyclic group and the like. Further, Ar₁ includes preferably an aromatic hydrocarbon group, more preferably a phenyl group, an alkylpheny group, an arylphenyl group, an alkenylphenyl group, an aminophenyl group, a naphthyl group, an arylalkynyl group and the like.

The above alkylphenyl group includes preferably an alkyl group, which may be a linear chain or a branched chain, having 1 to 10 carbon atoms. The alkyl group includes a methyl group, an ethyl group, an n-propyl group, an isopropyl group, an n-butyl group, an isobutyl group, a sec-butyl group, a tert-butyl group, an n-pentyl group, an isopentyl group, a neo-pentyl group, a tert-pentyl group, an n-hexyl group, an isohexyl group, a neo-hexyl group. The alkyl group may be bonded to anyone of the ortho position, the meta position and the para position of the phenyl group. Examples of the alkylphenyl group include an o-tolyl group, an m-tolyl group, a p-tolyl group, a 4-n-butylphenyl group, a 4-t-butylphenyl group and the like.
As the aryl group of the arylphenyl group, a substituted or unsubstituted phenyl group and naphthyl group are preferred. An alkyl group may be preferable for the substituent and includes the alkyl groups shown in the aforementioned alkylphenyl group. In addition, the aryl group may be a phenyl group substituted by an aryl group such as a phenyl group and the like. Examples of the arylphenyl group include an o-biphenylyl group, an m-biphenylyl group, a p-biphenylyl group, a 4-tolylphenyl group, a 3-tolylphenyl group, a terphenylyl group and the like.

The alkenylphenyl group may have preferably an alkenyl group having 2 to 20 carbon atoms, and a triarylalkenyl group may be more preferable and includes a triphenylvinyl group, a tritolylvinyl group, a tribiphenylvinyl group and the like. Examples of the alkenylphenyl group include a triphenylvinylphenyl group and the like.
The aminophenyl group may have preferably a diarylamino group for the amino group, and the arylamino group includes a diphenylamino group, a phenyltolylamino group and the like. Examples of the aminophenyl group include a diphenylaminophenyl group, a phenyltolylaminophenyl group and the like.
The naphthyl group includes a 1-naphthyl group and a 2-naphthyl group.
The arylalkynyl group may have preferably 8 to 20 carbon atoms and includes a phenylethynyl group, a tolylethynyl group, a biphenylylethynyl group, a naphthylethynyl group, a diphenylaminophenylethynyl group, an N-phenyltolylaminophenylethynyl group, a phenylpropynyl group and the like.

L in the general formula (I) represents a 2- to 6-valent moiety of a condensed polycyclic aromatic ring having 4 to 10 rings, preferably 4 to 6 rings. The condensed polycyclic aromatic ring includes a condensed polycyclic aromatic hydrocarbon ring and a condensed polycyclic aromatic heteroring.
Examples of the condensed polycyclic aromatic hydrocarbon ring include benzanthracene, naphthacene, pyrene, chrysene; triphenylene, benzo[c]phenanthrene, benzo[a]anthracene, pentacene, perylene, dibenzo[a,j]anthracene, dibenzo[a,h]anthracene, benzo[a]naphthacene, hexacene, anthanthrene, and the like. Benzanthracene, naphthacene, pentacene, and hexacene are preferable.
Examples of the condensed polycyclic aromatic hetero ring include naphto[2,1-f]isoquinolin, α-naphthaphenanthridine, phenanthrooxazole, quinolino[6,5-f]quinolin, benzo[b]thiophanthrene, benzo[g]thiophantrene, benzo[i]thiophanthrene, benzo[b]thiophanthraquinone.
In addition, a 2- to 6-valent moiety of a condensed polycyclic aromatic ring represented by L may have substituent, but it with no substituent is preferable.

Particularly preferable L includes 2- to 6-valent, preferably 2- to 4-valent moiety derived from naphthacene, pentacene or hexacene, which are linearly condensed benzene rings. However, when L is a 4-valent moiety derived from naphthacene, namely 5, 6, 11, 12-naphthacene-tetrayl group, four of Ar are not phenyl groups at the same time. Examples of the condensed polycyclic aromatic ring represented by L are illustrated as follows, but not limited thereto.

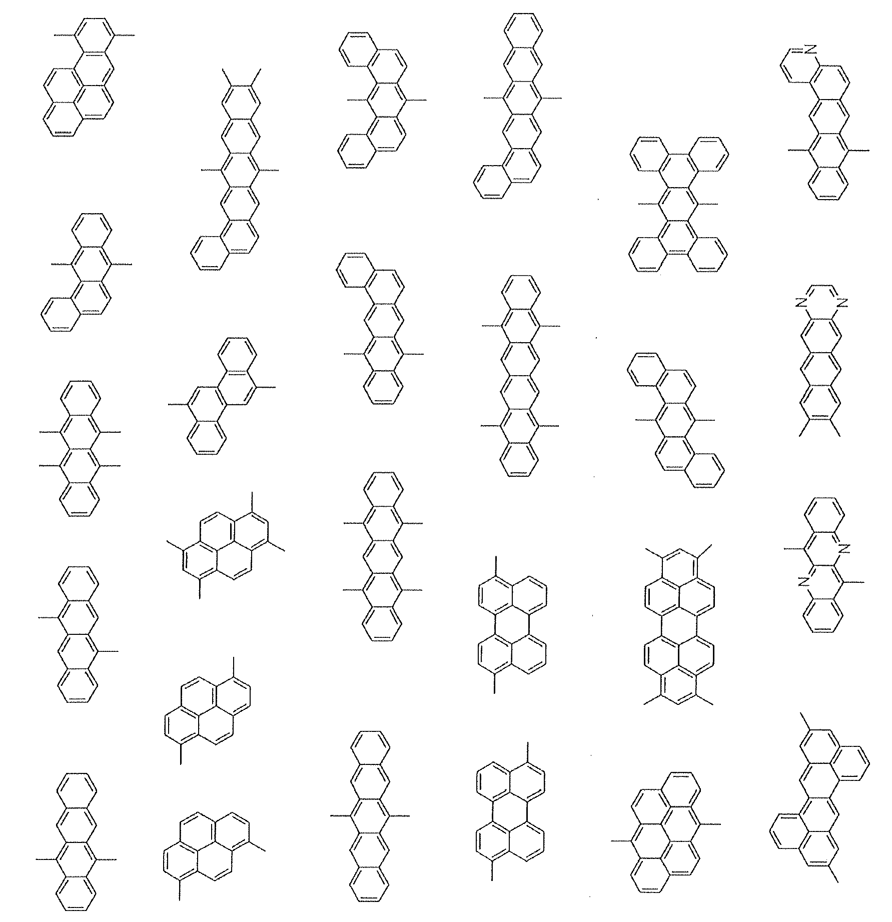

17 Further, in the compound containing a condensed ring represented by the general formula (I), it is preferred that Ar₁ represents a substituted or unsubstituted aromatic hydrocarbon group having 6 to 30 carbon atoms, a represents an integer of 2 to 4, L represents a substituted or unsubstituted 2⁻ to 4-valent moiety of the condensed polycyclic aromatic ring having 4 to 10 rings.

Examples of the compound containing a condensed ring represented by the general formula (I) are illustrated as follows, but not limited thereto.

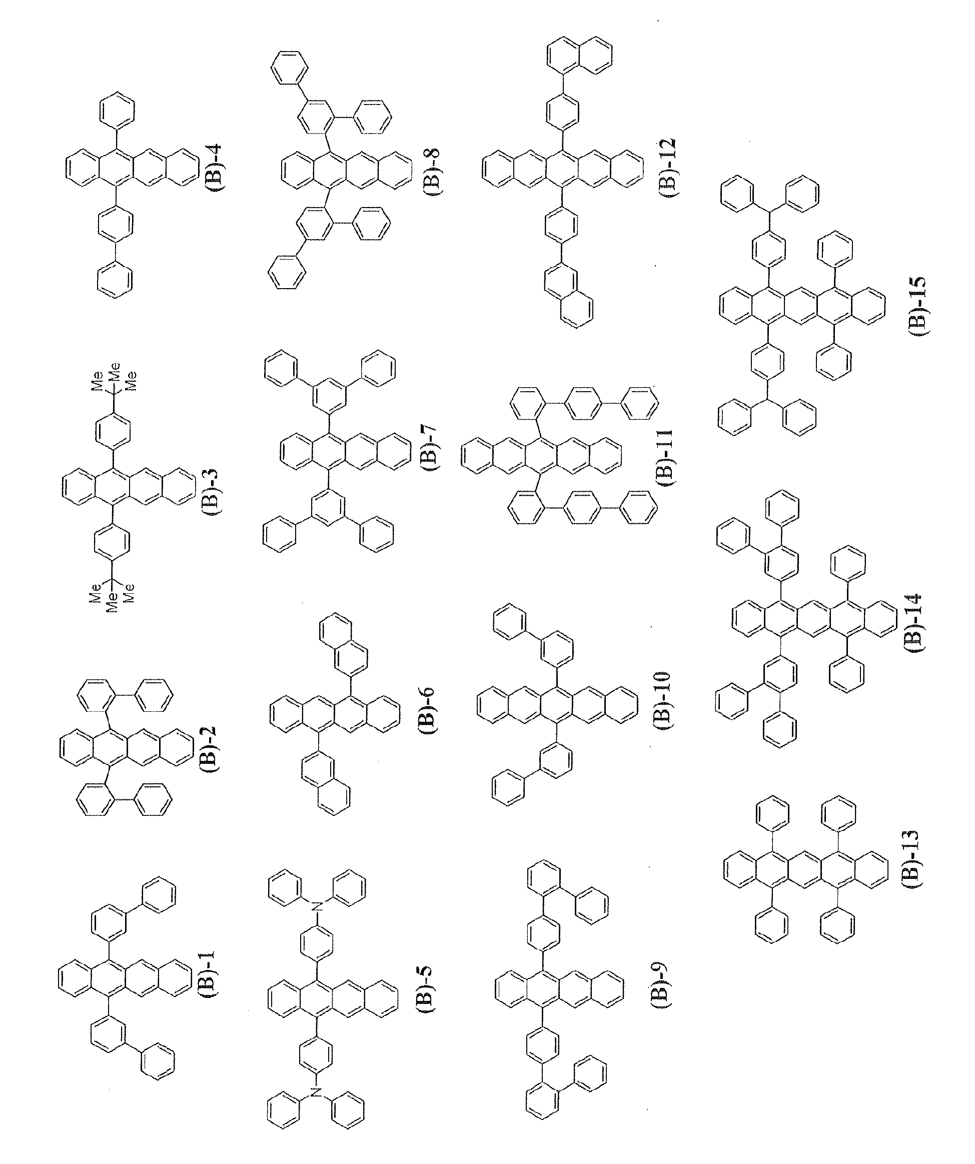

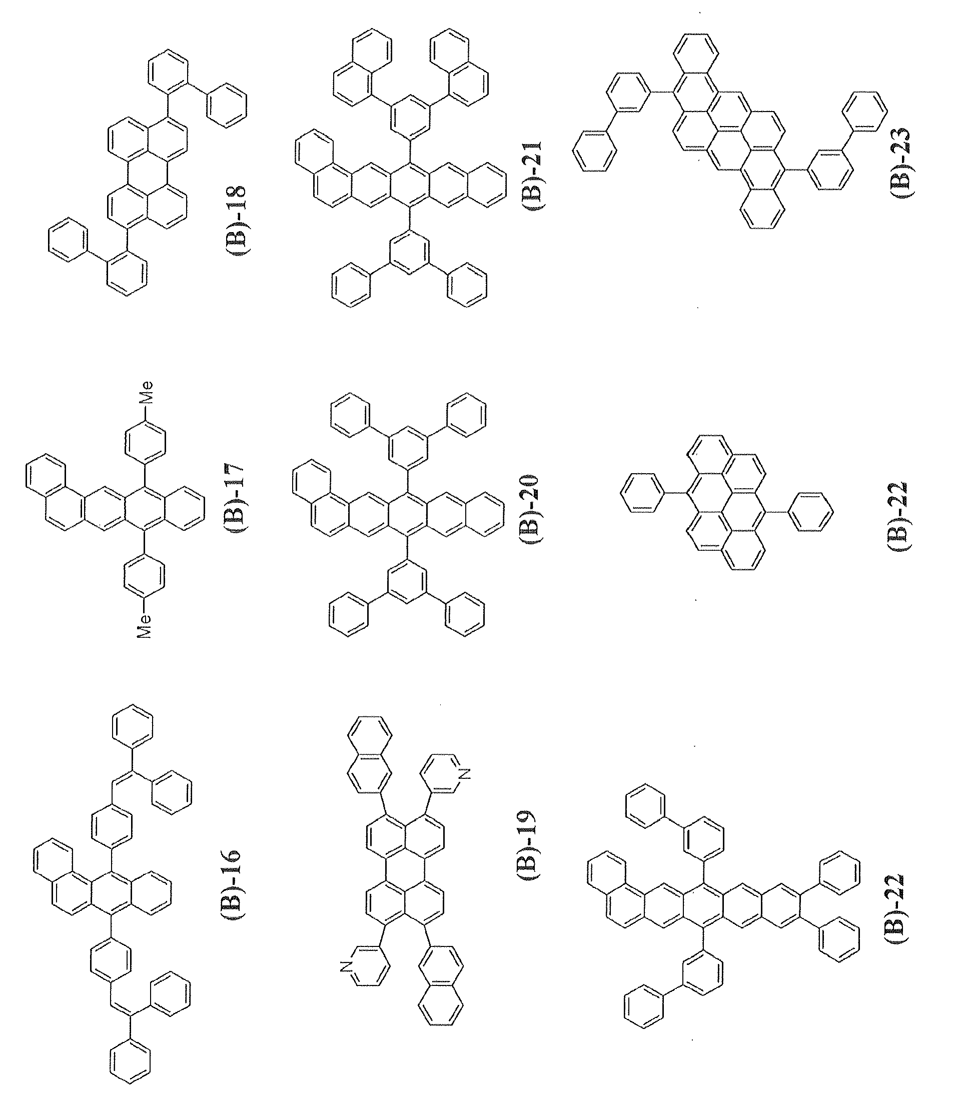

In the present invention, the ratio by weight between the component (A): an arylamine compound and the component (B): a compound containing a condensed ring may be 1:99 to 99:1 in the organic light emitting medium layer, and it may be properly decided depending on the variety of the compounds to be used. In particular, it is preferred to decide the ratio and/or the variety of the compounds of the components (A) and (B) so as to make a device having an optimal lifetime and current efficiency, since the component (A) has hole transportability and the component (B) has electron transportability.
The preferable ratio by weight between the components (A) and (B) is 1:99 to 20:80, and particularly high current efficiency is achieved in the range thereof. A thickness of the organic light emitting medium layer may be preferably 5 to 200 nm, and more preferably 10 to 40 nm since it is possible make impressed voltage of a device significantly low.

In this manner, by employing a combination of the components (A) and (B) for the organic light emitting medium layer, current efficiency may be 3 to 5 times higher and at least a 3 times longer lifetime than those layers containing only the component (B). The lifetime may be 10 or more times longer by optimization thereof.
In addition, by employing the arylamine compound represented by the general formula (II), especially those comprising amino group or condensed aromatic ring having branched alkyl group or 2 or more functional groups, it may be possible to avoid concentration quenching resulting from molecular association and to make it longer lasting, since there may be much steric hindrance resulting from interaction between the compounds containing a condensed ring and the arylamine compounds, or between the arylamine compounds.
Further, the compounds containing a condensed ring represented by the general formula (I) to be used for the component (B) give advantages for producing a device emitting a green light to a red light due to energy transfer from the compounds containing a condensed ring to the arylamine compounds, since the compounds containing a condensed ring is a material for emitting longer waves than those emitted by anthracene derivatives or bisanthracene derivatives. Therefore, it is possible to achieve further higher current efficiency.
Additionally, emitted a light in the range of from green to pure red by the organic EL devices of the present invention may be distinguished though the maximum emission wavelength of the emission spectra: green (maximum emission wavelength: 500 to 530 nm), yellow (maximum emission wavelength: 530 to 585 nm), orange (maximum emission wavelength: 585 to 595 nm), red (maximum emission wavelength: 595 to 620 nm), and pure red (maximum emission wavelength: 620 to 700 nm).

Further, it is possible to have devices having improved stability and heat resistance, since the organic light emitting medium layer becomes amorphous state resulting from combining the components (A) and (B). The component (B) may have preferably its glass transition temperature of 110°C or higher, and the component (A) may have preferably its glass transition temperature of 70°C or higher. It is possible to have the organic light emitting medium layer having glass transition temperature of 90°C or higher resulting from mixing compounds having such glass transition temperatures. Therefore, it is possible to provide with the layer having storage heat resistance of 500 hours or longer at 85°C, and, under the optimal conditions, 1000 hours or longer at 85°C.
The organic EL device of the present invention comprises an organic light emitting medium layer, which contains a combination of the components (A) and (B), sandwiched between a pair of electrodes, and also it is preferable to put various intermediate layers between the electrodes and the light emitting medium layer. The intermediate layers include, for example, a hole injecting layer, a hole transporting layer, an electron injecting layer, an electron transporting layer, and the like. A variety of organic or inorganic compounds has been known for them.

Typical examples of the construction of the organic EL device of the present invention include:
(1) an anode / a light emitting layer / a cathode
(2) an anode / a hole injecting layer / a light emitting layer / a cathode;
(3) an anode / a light emitting layer / an electron injecting layer / a cathode;
(4) an anode / a hole injecting layer / a light emitting layer / an electron injecting layer / a cathode;
(5) an anode / an organic semiconductor layer / a light emitting layer / a cathode;
(6) an anode / an organic semiconductor layer / an electron barrier layer / a light emitting layer / a cathode;
(7) an anode / an organic semiconductor layer / a light emitting layer / an adhesion improving layer / a cathode;
(8) an anode / a hole injecting layer / a hole transporting layer / a light emitting layer / an electron injecting layer / a cathode;
(9) an anode / an insulating layer / a light emitting layer / an insulating layer / a cathode;
(10) an anode / an inorganic semiconductor layer / an insulating layer / a light emitting layer / an insulating layer / a cathode;
(11) an anode / an organic semiconductor layer / an insulating layer / a light emitting layer / an insulating layer / a cathode;
(12) an anode / an insulating layer / a hole injecting layer / a hole transporting layer / a light emitting layer / an insulating layer / a cathode; and
(13) an anode / an insulating layer / a hole injecting layer / a hole transporting layer / a light emitting layer / an electron injecting layer / a cathode.
   Among those, the construction (8) is generally employed in particular; however, the construction of the organic EL device is not limited to those shown above as the examples.

In general, the organic EL device is produced on a substrate which transmits light. It is preferable that the substrate which transmits light has a transmittance of light of 50% or greater in the visible region of 400 to 700 nm. It is also preferable that a flat and smooth substrate is employed.
As the substrate which transmits light, for example, glass sheet and synthetic resin sheet are advantageously employed. Specific examples of the glass sheet include soda lime glass, glass containing barium and strontium, lead glass, aluminosilicate glass, borosilicate glass, barium borosilicate glass, quartz and the like. In addition, specific examples of the synthetic resin sheet include sheet made of polycarbonate resins, acrylic resins, polyethylene terephthalate resins, polyether sulfide resins, polysulfone resins and the like.

Next, the anode in the organic EL device of the present invention comprises preferably electrode materials such as metal, alloy, electric conductive compounds or mixture thereof, which have a work function of 4 eV or greater. Examples of the electrode material include metal such as Au and electric conductive materials such as CuI, ITO (indium tin oxide), SnO₂, ZnO, and In-Zn-O. The anode can be prepared by forming a thin film of the electrode material described above in accordance with a process such as a vapor deposition process or a sputtering process. When the light emitted from the light emitting layer is observed through the anode, it is preferable that the anode has a transmittance of the emitted light greater than 10 %. It is also preferable that the sheet resistivity of the anode is several hundred Ω/□ or smaller. In addition, the thickness of the anode is, in general, selected in the range of from 10 nm to 1µm and preferably in the range of from 10 to 200 nm depending on a kind of the materials.

Next, the cathode in the organic EL device of the present invention comprises electrode materials such as metal, alloy, electric conductive compounds or mixture thereof, which have a work function of 4 eV or smaller. Examples of the electrode material include sodium, sodium-potassium alloy, magnesium, lithium, magnesium-silver alloy, aluminum / aluminum oxide, Al/Li₂O, Al/LiO₂, Al/LiF, aluminum /lithium alloy, indium, rare earth metal, and the like.
The cathode can be prepared by forming a thin film of the electrode material described above in accordance with a process such as the vapor deposition process and the sputtering process.
When the light emitted from the light emitting layer is observed through the cathode, it is preferable that the cathode has a transmittance of the emitted light greater than 10 %. It is also preferable that the sheet resistivity of the cathode is several hundred Ω/□ or smaller. The thickness of the cathode is, in general, selected in the range of from 10 nm to 1. µ m and preferably in the range of from 50 to 200 nm.

In the organic EL device of the present invention, it is preferable to allocate at least a layer ("a layer" will be occasionally referred to as "a surface layer", hereinafter) selected from the group consisting of a chalcogenide layer, a metal halide layer and a metal oxide layer on at least a surface of the pair of the electrode prepared as above. Specifically, it is preferable to allocate a chalcogenide layer of metal (including oxide) such as silicon and aluminum on the anode surface on the side of the light emitting medium layer, and a metal halide layer or a metal oxide layer on the cathode surface on the side of the light emitting medium layer. The allocation results in stabilization of driving.
The above chalcogenide includes, for example, preferably SiOₓ(1≦X≦2), AlOₓ(1≦X≦1.5), SiON, SiAlON, and the like. The metal halide includes, for example, preferably LiF, MgF₂, CaF₂, rare earth metal fluoride, and the like. The metal oxide includes, for example, preferably, Cₛ₂O, Lᵢ₂O, MgO, SrO, BaO, CaO and the like.

In the organic EL device of the present invention, since it is possible to obtain good electron transportability and hole transportability of the light emitting medium layer depending on the ratio between the components (A) and (B) to be used, it is possible to leave out an intermediate layer such as the hole injecting layer, the hole transporting layer, or the electron injecting layer. The surface layer may be preferably allocated even this case.
In addition, in the organic EL device of the present invention, since it is preferable to allocate a mixture zone of an electron transfer compound and a reductive dopant, or a mixture zone of a hole transfer compound and an oxidative dopant on at least a surface of the pair of the electrode prepared as above. In this way, it becomes easy to inject and transport electrons from the mixture zone into the light emitting medium, since the electron transfer compound is reduced to anion. Further, the hole transfer compound is oxidized to cation and the mixture zone is apt to inject and transport holes into the light emitting medium. Examples of preferable oxidative dopant include a variety of Lewis acids and acceptor compounds. Examples of preferable reductive dopant include alkaline metals, alkaline metal compounds, alkaline earth metals, rare earth metals, and a mixture thereof.

In the organic EL device of the present invention, the light emitting medium layer has the following functions:
(i) The injecting function: the function of injecting holes from the anode or the hole injecting layer and injecting electrons from the cathode or the electron injecting layer when an electric field is applied;
(ii) The transporting function: the function of transporting injected charges (electrons and holes) by the force of the electric field; and
(iii) The light emitting function: the function of providing the field for recombination of electrons and holes and leading the recombination to the emission of light.
   As the process for forming the light emitting layer, a well known process such as the vapor deposition process, the spin coating process and the LB process may be employed. It is preferable that a light emitting medium layer is a molecular sedimentation film particularly. Here, the molecular sedimentation film is defined as a thin film formed by sedimentation of a gas phase material compound or a film formed by condensation from a solution or a liquid phase material compound. The molecular sedimentation film is distinguished from a thin film (a molecular build-up film) formed by the LB process, base on the differences in agglomeration structures and higher-order structures, and also the differences resulting from functionalities thereof.

In addition, as shown in Japanese Patent Laid-open No. Show a 57(1982)-51781, to form a light emitting medium layer, a thin film may be formed in accordance with the spin coating and the like of the solution to be prepared by dissolving a binder such as resin and a material compound in solvent.
In the present invention, any publicly known organic light emitting medium other than the components (A) and (B) may be optionally contained in the light emitting medium layer, and also a light emitting medium layer containing other publicly known organic light emitting medium may be laminated with the light emitting medium layer containing the compound of the present invention in an extent of not obstructing to achieve the objective of the present invention.

Next, the hole injecting / transporting layer are layers which assist injection of holes into the light emitting layer and transport the holes to the light emitting zone. The layers exhibit a great mobility of holes and, in general, have an ionization energy as small as 5.5 eV or smaller. For the hole injecting layer and the hole transporting layer, a material which transports holes to the light emitting layer at a small strength of the electric field is preferable. A material which exhibits, for example, a mobility of holes of at least 10⁻⁶ cm²/V·sec under application of an electric field of from 10⁴ to 10⁶ V/cm is preferable. As for such material, any arbitrary material selected from conventional material commonly used as a charge transporting material for the holes in photo conducting materials and well known material employed for the hole injecting layer in the EL device is usable.
To form the hole injecting / transporting layer, a thin film may be formed from the material for the hole injecting layer or the hole transporting layer, respectively, in accordance with a well known process such as the vacuum vapor deposition process, the spin coating process, the casting process and the LB process. Although the thickness of the hole injecting / transporting layer is not particularly limited, the thickness is usually from 5 nm to 5 µm.

The electron injecting / transporting layer in the organic EL device of the present invention is a layer which assists injection of electrons into the light emitting medium layer and exhibits a great mobility of electrons. The adhesion improving layer is a layer comprising the material which is particularly adhesive to the cathode. As the material for the electron injecting layer, 8-hydroxyquinoline or metal complexes of derivatives thereof are preferable. Examples of the 8-hydroxyquinoline and metal complexes of derivatives thereof include metal chelates of oxinoid compounds including chelates of oxine (in general, 8-quinolinol or 8-hydroxyquinoline). For example, tris(8-quinolinol)aluminum (Alq) can be employed as the electron injecting material.
In general, an organic EL device tends to form defects in pixels due to leak and short circuit since an electric field is applied to ultra-thin films. To prevent the formation of the defects, a layer of an insulating thin film may be inserted between the pair of electrodes.

Examples of the material employed for the insulating layer include aluminum oxide, lithium fluoride, lithium oxide, cesium fluoride, cesium oxide, magnesium oxide, magnesium fluoride, calcium oxide, calcium fluoride, aluminum nitride, titanium oxide, silicon oxide, germanium oxide, silicon nitride, boron nitride, molybdenum oxide, ruthenium oxide, vanadium oxide and the like. Mixtures and laminates of the above compounds can also be employed.
To produce an organic EL device of the present invention, for example, an anode, a light emitting medium layer and, where necessary, a hole injecting layer and an electron injecting layer are formed in accordance with the aforementioned process using the aforementioned materials, and a cathode is formed in the last step. An organic EL device may be produced by forming the aforementioned layers in the order reverse to that described above, i.e., a cathode being formed in the first step and an anode in the last step.

An embodiment of the process for producing an organic EL device having a construction in which an anode, a hole injecting layer, a light emitting medium layer, an electron injecting layer and a cathode are disposed sequentially on a light-transmitting substrate will be described in the following. On a suitable light-transmitting substrate, a thin film made of a material for the anode is formed in accordance with the vapor deposition process or the sputtering process so that the thickness of the formed thin film is 1 µm or smaller and preferably in the range of from 10 to 200 nm. The formed thin film is employed as the anode. Next, the hole injecting layer was formed on the anode formed above. The hole injecting layer can be formed in accordance with the vacuum vapor deposition process, the spin coating process, the casting process or the LB process, as described above. The vacuum vapor deposition process is preferable since a uniform film can be easily obtained and the possibility of formation of pin holes is small. When the hole injecting layer is formed in accordance with the vacuum vapor deposition process, in general, it is preferable that the deposition conditions are suitably selected in the following ranges: temperature of the deposition source: 50 to 450°C, vacuum level: 10⁻⁷ to 10⁻³ Torr; deposition rate: 0.01 to 50 nm/second; temperature of the substrate: -50 to 300°C; and film thickness: 5 nm to 5 µm; although the conditions of the vacuum vapor deposition are different depending on the employed compound (the material for the hole injecting layer) and the crystal structure and the recombination structure of the hole injecting layer to be formed.

Subsequently, the light emitting medium layer is formed on the hole injecting layer formed above. Also the formation of the light emitting medium layer can be made by forming the light emitting medium according to the present invention into a thin film in accordance with the vacuum vapor deposition process, the sputtering process, the spin coating process or the casting process. The vacuum vapor deposition process is preferable since a uniform film can be easily obtained and the possibility of formation of pinholes is small. Then the light emitting medium layer is formed in accordance with the vacuum vapor deposition process, in general, the conditions of the vacuum vapor deposition process can be selected in the same ranges as those described for the vacuum vapor deposition of the hole injecting layer although the conditions are different depending on a compound to be used. It is preferable that the film thickness is in the range of from 10 to 40 nm.
Next, the electron injecting layer is formed on the light emitting medium layer formed above. Similarly to the hole injecting layer and the light emitting medium layer, it is preferable that the electron injecting layer is formed in accordance with the vacuum vapor deposition process since a uniform film must be obtained. The conditions of the vacuum vapor deposition can be selected in the same ranges as those for the hole injecting layer and the light emitting medium layer.
In the last step, the cathode is formed on the electron injecting layer, and an organic EL device can be fabricated. The cathode is made of a metal and can be formed in accordance with the vacuum vapor deposition process or the sputtering process. It is preferable that the vacuum vapor deposition process is employed in order to prevent the lower organic layers from damages during the formation of the film.
In the above production of the organic EL device, it is preferable that the above layers from the anode to the cathode are formed successively while the production system is kept in a vacuum after being evacuated.

When a direct voltage is applied on the organic EL device produced in the above manner, when a direct voltage of 3 to 40 V is applied in the condition that the anode is connected to a positive electrode (+) and the cathode is connected to a negative electrode (-), then a light emitting is observed. When the connection is reversed, no electric current is produced and no light is emitted at all. When an alternating voltage is applied on the organic EL device, the uniform light emission is observed only in the condition that the polarity of the anode is positive and the polarity of the cathode is negative. When an alternating voltage is applied on the organic EL device, any type of wave shape can be employed.

### [Examples]

This invention will be described in further detail with reference to the examples, which do not limit the scope of this invention.

### Example 1

On a glass substrate of 25 mm×75 mm×1.1 mm thickness, a transparent electrode of an indium tin oxide film having a film thickness of 120 nm was allocated. The above glass substrate was cleaned by application of ultrasonic wave in isopropyl alcohol for 5 minutes and then by exposure to ozone generated by ultraviolet light for 30 minutes. Subsequently, the substrate was set to a vacuum vapor deposition apparatus.
As a hole injecting layer, N',N"-bis[4-(diphenylamino)phenyl]-N',N"-diphenylbiphenyl-4,4'-diamine was deposited on the substrate, thereby forming a film having a film thickness of 60 nm, and then as a hole transporting layer, N,N'-bis[4'-{N-(naphthyl-1-yl)-N-phenyl}aminobiphenyl-4-yl]-N-phenylamine was deposited thereby forming a film having a thickness of 20 nm. Subsequently, as a light emitting layer, the above compounds (B)-7 and (A)-9 at the ratio by weight of 40 : 3 were deposited at the same time thereby forming a film having a film thickness of 40 nm.
Further, as an electron injecting layer, tris(8-hydroxyquinolinato)aluminum was deposited thereby forming a film having a film thickness of 20 nm. Thereafter, lithium fluoride was deposited thereby forming a film having a film thickness of 0.3 nm, followed by deposition of aluminum to form a film having a film thickness of 150 nm. The aluminum / lithium fluoride work as a cathode. Thus the organic EL device was fabricated.
The obtained device was tested under an electricity application, a green light emission with an emission luminance of 2,200 cd/m² was observed at a voltage of 6.5 V and a current density of 10 mA/cm². In addition, when the device was continuously tested under an electricity application at an initial luminance of 5,000 cd/m², the half lifetime was found to be 2,750 hours.
As mentioned above, a device emitting a green light exhibiting high current efficiency and having a long lifetime was obtained by combining component (A) and component (B). In addition, the device was tested under an electricity application after holding in storage at 85°C for 1,000 hours, and no change of the emission luminance thereof was found.

### Example 2

An organic device was fabricated similarly as Example 1 except that the compound (A)-1 in place of the compound (A)-9 was used to form a light emitting layer.
The obtained device was tested under an electricity application, a green light emission with an emission luminance of 950 cd/m² was observed at a voltage of 6.5 V and a current density of 10 mA/cm². In addition, when the device was continuously tested under an electricity application at an initial luminance of 5,000 cd/m², the half lifetime was found to be 1,750 hours. Further, the device was tested under an electricity application after holding in storage at 85°C for 1,000 hours, and no change of the emission luminance thereof was found.

### Example 3

An organic device was fabricated similarly as Example 1 except that the compound (A)-20 in place of the compound (A)-9 was used to form a light emitting layer.
The device was tested under an electricity application, a green light emission with an emission luminance of 2400 cd/m² was observed at a voltage of 6.5 V and a current density of 10 mA/cm². In addition, when the device was continuously tested under an electricity application at an initial luminance of 5,000 cd/m², the half lifetime was found to be 2,500 hours. Further, the device was tested under an electricity application after holding in storage at 85°C for 1,000 hours, and no change of the emission luminance thereof was found.

### Example 4

An organic device was fabricated similarly as Example 1 except that the compounds (B)-18 and (A)-10 in place of the compounds (B)-7 and (A)-9 were used to form a light emitting layer.
The device was tested under an electricity application, a green light emission with an emission luminance of 1,500 cd/m² was observed at a voltage of 6.5 V and a current density of 10 mA/cm². In addition, when the device was continuously tested under an electricity application at an initial luminance of 5,000 cd/m², the half lifetime was found to be 1,250 hours. Further, the device was tested under an electricity application after holding in storage at 85°C for 1,000 hours, and no change of the emission luminance thereof was found.

### Example 5

An organic device was fabricated similarly as Example 1 except that the compounds (B)-9 and (A)-27 in place of the compounds (B)-7 and (A)-9 were used to form a light emitting layer.
The device was tested under an electricity application, a yellow light emission with an emission luminance of 1,980 cd/m² was observed at a voltage of 6.5 V and a current density of 10 mA/cm². In addition, when the device was continuously tested under an electricity application at an initial luminance of 5,000 cd/m², the half lifetime was found to be 1,900 hours. Further, the device was tested under an electricity application after holding in storage at 85°C for 1,000 hours, and no change of the emission luminance thereof was found.

### Example 6

An organic device was fabricated similarly as Example 1 except that the compounds (B)-8 and (A)-35, in place of the compounds (B)-7 and (A)-9, at the ratio by weight of 40 : 10 were deposited at same time, thereby forming a film thereof having a film thickness of 40 nm.
The device was tested under an electricity application, a red light emission with an emission luminance of 690 cd/m² was observed at a voltage of 8.0 V and a current density of 10 mA/cm². In addition, when the device was continuously tested under an electricity application at an initial luminance of 3,000 cd/m², the half lifetime was found to be 2,900 hours. Further, the device was tested under an electricity application after holding in storage at 85°C for 1,000 hours, and no change of the emission luminance thereof was found.

### Example 7

An organic device was fabricated similarly as Example 6 except that the compound (A)-39 in place of the compound (A)-35 was used to form a light emitting layer.
The device was tested under an electricity application, a pure red light emission with an emission luminance of 550 cd/m² was observed at a voltage of 8.0 V and a current density of 10 mA/cm². In addition, when the device was continuously tested under an electricity application at an initial luminance of 3,000 cd/m², the half lifetime was found to be 1,900 hours. Further, the device was tested under an electricity application after holding in storage at 85°C for 1,000 hours, and no change of the emission luminance thereof was found.

### Example 8

An organic device was fabricated similarly as Example 6 except that the compounds (B)-11 and (A)-40 in place of the compounds (B)-8 and (A)-35 were used to form a light emitting layer.
The device was tested under an electricity application, a pure red light emission with an emission luminance of 350 cd/m² was observed at a voltage of 8.0 V and a current density of 10 mA/cm². In addition, when the device was continuously tested under an electricity application at an initial luminance of 3,000 cd/m², the half lifetime was found to be 1,000 hours. Further, the device was tested under an electricity application after holding in storage at 85°C for 1,000 hours, and no change of the emission luminance thereof was found.

### Example 9

An organic device was fabricated similarly as Example 6 except that the compounds (B)-9 and 3,11-bis(diphenylamino)-7,14-diphenylacenaphtho-[1,2-k]-fluoranthene in place of the compounds (B)-8 and (A)-35 were used to form a light emitting layer.
The device was tested under an electricity application, a yellow light emission with an emission luminance of 1,150 cd/m² was observed at a voltage of 8.0 V and a current density of 10 mA/cm². In addition, when the device was continuously tested under an electricity application at an initial luminance of 5,000 cd/m², the half lifetime was found to be 1,050 hours. Further, the device was tested under an electricity application after holding in storage at 85°C for 1,000 hours, and no change of the emission luminance thereof was found.

### Comparative Example 1

An organic device was fabricated similarly as Example 1 except that the compound (B)-7 only in place of the compounds (B)-7 and (A)-9 was used to form a light emitting layer having a film thickness of 40 nm.
The device was tested under an electricity application, a yellow light emission with an emission luminance of 200 cd/m² was observed at a voltage of 6.5 V and a current density of 10 mA/cm². In addition, when the device was continuously tested under an electricity application at an initial luminance of 5,000 cd/m², the half lifetime was found to be 150 hours.

### Comparative Example 2

An organic device was fabricated similarly as Example 1 except that tris(8-quinolinol)aluminum and the following compound C545T, in place of the compounds (B)-7 and (A)-9, at the ratio by weight of 40 : 0.5 were deposited at same time, thereby forming a film thereof having a film thickness of 40 nm.
The device was tested under an electricity application, a green light emission with an emission luminance of 1.000 cd/m² was observed at a voltage of 6.5 V and a current density of 10 mA/cm². In addition, when the device was continuously tested under an electricity application at an initial luminance of 5,000 cd/m², the half lifetime was found to be as short as 780 hours.

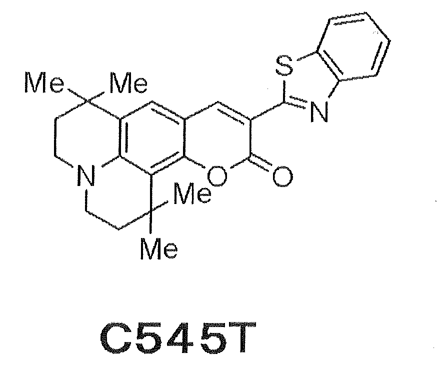

### Comparative Example 3

An organic device was fabricated similarly as Example 6 except that tris(8-quinolinol)aluminum and the following compound DCJTB in place of the compounds (B)-8 and (A)-35 were used to form a light emitting layer.
The device was tested under an electricity application, a red light emission with an emission luminance of 150 cd/m² was observed at a voltage of 6.5 V and a current density of 10 mA/cm². In addition, when the device was continuously tested under an electricity application at an initial luminance of 3,000 cd/m², the half lifetime was found to be as short as 200 hours.

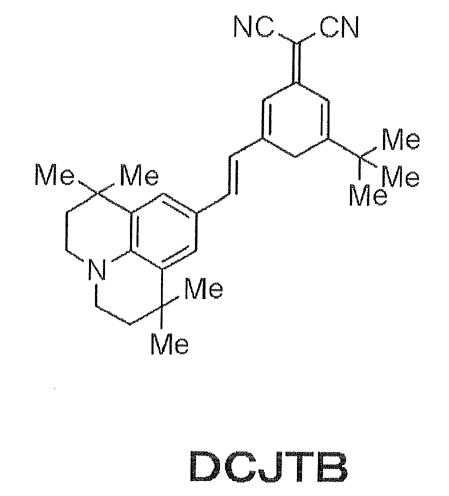

### Comparative Example 4

An organic device was fabricated similarly as Example 6 except that 10,10'-bis[1,1',4',1"] terphenyl-2-yl-9,9"bianthracenyl and the compound (A)-39 in place of the compounds (B)-8 and (A)-35 were used to form a light emitting layer. The device was tested under an electricity application, an orange light emission with an emission luminance of 800 cd/m² was observed at a voltage of 6.5 V and a current density of 10 mA/cm². Unlike the device obtained in example 6, no red light emission was observed.

### INDUSTRIAL APPLICABILITY

As explained above in details, the organic EL device of the present invention has excellent heat resistance and a long lifetime, exhibits high current efficiency, and emits a light in the range of from green to pure red.
Therefore, it is useful for a practical organic EL device, and suitable for in particular for a display for full color.

## Claims

1. An organic electroluminescent device comprising a pair of electrodes and an organic light emitting medium layer sandwiched between the said electrodes wherein the organic light emitting medium layer contains a component (A): at least one selected from substituted or unsubstituted arylamine compounds having 10 to 100 carbon atoms, and a component (B): at least one selected from compounds containing a condensed ring represented by the general formula (I):
(Ar₁)ₐ-L (I)
wherein, Ar₁ represents a substituted or unsubstituted aromatic hydrocarbon group having 6 to 30 carbon atoms, or a substituted or unsubstituted aromatic heterocyclic group having 3 to 30 carbon atoms, a represents an integer of 2 to 6, a plural Ar₁ may be the same or different from each other, and L represents a substituted or unsubstituted a-valent moiety of a condensed polycyclic aromatic ring having 4 to 10 rings.

2. The organic electroluminescent device according to Claim 1, wherein an arylamine compound for the component (A) is represented by the following general formula; 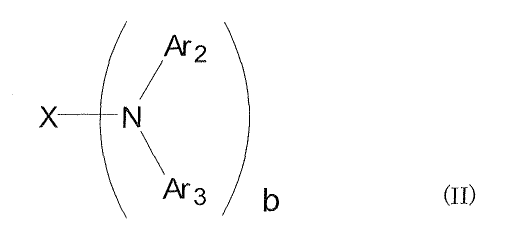 wherein, X represents a substituted or unsubstituted condensed aromatic ring group having 10 to 40 ring carbon atoms, Ar₂ and Ar₃ each independently represents substituted or unsubstituted monovalent aromatic hydrocarbon group having 6 to 40 carbon atoms, or substituted or unsubstituted monovalent aromatic heterocyclic group having 3 to 40 carbon atoms, and b represents an integer of 1 to 4.

3. The organic electroluminescent device according to Claim 2, wherein X represents a moiety of naphthalene, phenanthrene, fluoranthene, anthracene, pyrene, perylene, coronene, chrysene, picene, diphenylanthracene, fluorene, triphenylene, rubicene, benzanthracene, dibenzanthracene, acenaphthofluoranthene, tribenzopentaphene, fluoranthenofluoranthene, benzodifluoranthene, benzofluoranthene or diindenoperylene.

4. The organic electroluminescent device according to Claim 2, wherein the above general formula (II) represents a compound represented by the following general formula (II-a): 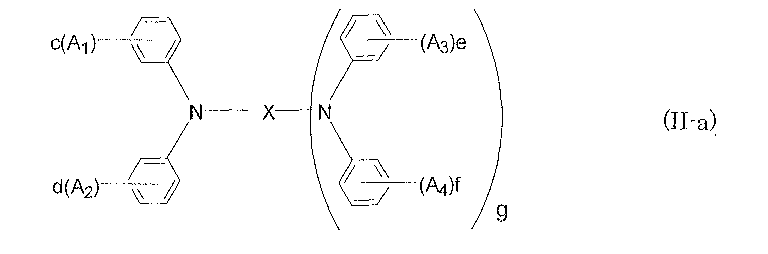 wherein, X represents a condensed aromatic ring group having 10 to 40 ring carbon atoms, A₁ to A₄ each independently represents a hydrogen atom, a substituted or unsubstituted alkyl group having 1 to 50 carbon atoms, a substituted or unsubstituted aromatic hydrocarbon group having 5 to 50 carbon atoms, a substituted or unsubstituted aralkyl group having 7 to 50 carbon atoms, a substituted or unsubstituted cycloalkyl group having 3 to 50 ring carbon atoms, a substituted or unsubstituted alkoxyl group having 1 to 50 carbon atoms, a substituted or unsubstituted aryloxyl group having 5 to 50 ring carbon atoms, a substituted or unsubstituted arylamino group having 5 to 50 ring carbon atoms, or a substituted or unsubstituted alkylamino group having 1 to 20 carbon atoms, c, d, e, and f each represents an integer of 0 to 5, g represents an integer of 0 to 4, when c, d, e, and/or f represent 2 or larger, a plural A₁ to A₄ each may be the same or different from each other, and also may bond each other to form a saturated or unsaturated ring;
however, at least one of A₁ to A₄ represents substituted or unsubstituted sec- or tert-alkyl group having 3 to 10 carbon atoms.

5. The organic electroluminescent device according to Claim 2, wherein the above general formula (II) represents a compound represented by the following general formula (II-a'): 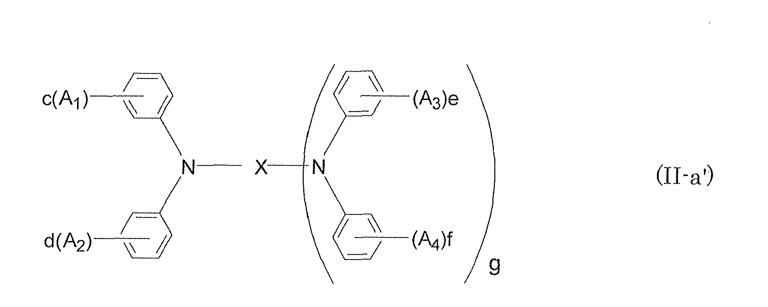 wherein, X represents a condensed aromatic ring group having 10 to 40 ring carbon atoms, A₁ to A₄ each independently represents a hydrogen atom, a substituted or unsubstituted alkyl group having 1 to 50 carbon atoms, a substituted or unsubstituted aromatic hydrocarbon group having 5 to 50 carbon atoms, a substituted or unsubstituted aralkyl group having 7 to 50 carbon atoms, a substituted or unsubstituted cycloalkyl group having 3 to 50 ring carbon atoms, a substituted or unsubstituted alkoxyl group having 1 to 50 carbon atoms, a substituted or unsubstituted aryloxyl group having 5 to 50 ring carbon atoms, a substituted or unsubstituted arylamino group having 5 to 50 ring carbon atoms, or a substituted or unsubstituted alkylamino group having 1 to 20 carbon atoms, c, d, e, and f each represents an integer of 0 to 5, g represents an integer of 0 to 4, when c, d, e, and /or f represent 2 or larger, a plural A₁ to A₄ each may be the same or different from each other, and also may bond each other to form a saturated or unsaturated ring;
however, at least one of c, d, e, and f represents an integer of 2 or larger.

6. The organic electroluminescent device according to Claim 2, wherein the above general formula (II) represents a compound represented by the following general formula (II-b): 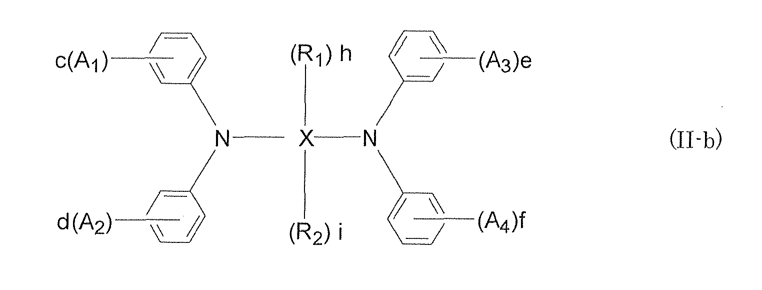 wherein, X represents a condensed aromatic ring group having 10 to 40 ring carbon atoms, A₁ to A₄ each independently represents a hydrogen atom, a substituted or unsubstituted alkyl group having 1 to 50 carbon atoms, a substituted or unsubstituted aromatic hydrocarbon group having 5 to 50 carbon atoms, a substituted or unsubstituted aralkyl group having 7 to 50 carbon atoms, a substituted or unsubstituted cycloalkyl group having 3 to 50 ring carbon atoms, a substituted or unsubstituted alkoxyl group having 1 to 50 carbon atoms, a substituted or unsubstituted aryloxyl group having 5 to 50 ring carbon atoms, a substituted or unsubstituted arylamino group having 5 to 50 ring carbon atoms, or a substituted or unsubstituted alkylamino group having 1 to 20 carbon atoms,
c, d, e, and f each represents an integer of 0 to 5, when c, d, e, and / or f represent 2 or larger, a plural A₁ to A₄ each may be the same or different from each other, and also may bond each other to form a saturated or unsaturated ring;
R₁ and R₂ each independently represents a hydrogen atom, a substituted or unsubstituted alkyl group having 1 to 10 carbon atoms, a substituted or unsubstituted aromatic hydrocarbon group having 6 to 20 carbon atoms, a substituted or unsubstituted aralkyl group having 7 to 50 carbon atoms, a substituted or unsubstituted cycloalkyl group having 3 to 50 carbon atoms, a substituted or unsubstituted alkoxyl group having 1 to 50 carbon atoms, a substituted or unsubstituted aryloxyl group having 5 to 50 ring carbon atoms,
h and i each independently represents an integer of 0 to 2,
however, at least one of A₁ to A₄ represents substituted or unsubstituted sec⁻ or tert-alkyl group having carbon atoms of 3 to 10.

7. The organic electroluminescent device according to Claim 2, wherein the above general formula (II) represents a compound represented by the following general formula (II-b'): 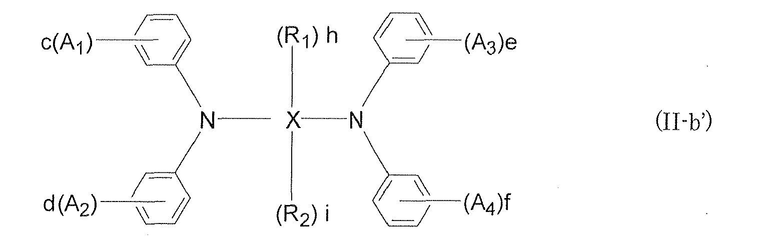 wherein, X represents a condensed aromatic ring group having 10 to 40 ring carbon atoms, A₁ to A₄ each independently represents a hydrogen atom, a substituted or unsubstituted alkyl group having 1 to 50 carbon atoms, a substituted or unsubstituted aromatic hydrocarbon group having 5 to 50 carbon atoms, a substituted or unsubstituted aralkyl group having 7 to 50 carbon atoms, a cycloalkyl group having 3 to 50 carbon atoms, a substituted or unsubstituted alkoxyl group having 1 to 50 carbon atoms, a substituted or unsubstituted aryloxyl group having 5 to 50 carbon atoms, a substituted or unsubstituted arylamino group having 5 to 50 carbon atoms, or a substituted or unsubstituted alkylamino group having 1 to 20 carbon atoms,
c, d, e, and f each represents an integer of 0 to 5,
when c, d, e, and/or f represent 2 or larger, a plural A₁ to A₄ each may be the same with or different from each other, and also may bond each other to form a saturated or unsaturated ring;
R₁ and R₂ each independently represents a hydrogen atom, a substituted or unsubstituted alkyl group having 1 to 10 carbon atoms, a substituted or unsubstituted aromatic hydrocarbon group having 6 to 20 carbon atoms, a substituted or unsubstituted aralkyl group having 7 to 50 carbon atoms, a substituted or unsubstituted cycloalkyl group having 3 to 50 carbon atoms, a substituted or unsubstituted alkoxyl group having 1 to 50 carbon atoms, a substituted or unsubstituted aryloxyl group having 5 to 50 ring carbon atoms,
h and i each independently represents an integer of 0 to 2,
however, at least one of c, d, e, and f represents an integer of 2 or larger.

8. The organic electroluminescent device according to Claim 1, wherein, in a compound containing a condensed ring represented by the general formula (I) for the component (B), Ar₁ represents a substituted or unsubstituted aromatic hydrocarbon group having 6 to 30 carbon atoms, a represents an integer of 2 to 4 and L represents a 2- to 4-valent moiety of condensed polycyclic aromatic ring having 4 to 10 rings.

9. The organic electroluminescent device according to Claim 8, wherein, in a compound containing a condensed ring represented by the general formula (I) for the component (B), a condensed polycyclic aromatic ring represented by L represents benzanthracene, naphthacene, pentacene or hexacene.

10. The organic electroluminescence device according to 1, wherein the ratio by weight between the component (A) and the component (B) contained in the aforementioned organic light emitting medium layer may be 1:99 to 20:80.

11. The organic electroluminescent device according to Claim 1, wherein at least a layer selected from the group consisting of a chalcogenide layer, a metal halide layer and a metal oxide layer is allocated on at least a surface of a pair of electrodes.

12. The organic electroluminescent device according to Claim 1, wherein a mixture zone of a reductive dopant and a organic material, or a mixture zone of an oxidative dopant and an organic material is allocated on at least a surface of a pair of electrodes.
